# EUROPEAN PATENT APPLICATION

(11) **EP 4 228 007 A1**
(43) Date of publication of application: **16.08.2023**
(21) Application number: 20962920.3
(22) Date of filing: 27.11.2020
(51) Int. Cl.: H01L 29/778

(54) **SEMICONDUCTOR DEVICE AND MANUFACTURING METHOD THEREFOR**

(71) Applicant: Huawei Technologies Co., Ltd., Shenzhen, Guangdong 518129 (CN)
(72) Inventor: TANG, Cen, Shenzhen, Guangdong 518129 (CN); RAO, Jin, Shenzhen, Guangdong 518129 (CN); LIU, Tao, Shenzhen, Guangdong 518129 (CN); LI, Haijun, Shenzhen, Guangdong 518129 (CN); LU, Wei, Shenzhen, Guangdong 518129 (CN); LE, Lingcong, Shenzhen, Guangdong 518129 (CN); MA, Juncai, Shenzhen, Guangdong 518129 (CN); ZHANG, Zhili, Shenzhen, Guangdong 518129 (CN)
(74) Representative: Pfenning, Meinig & Partner mbB
(86) International application number: PCT/CN2020/132301
(87) International publication number: WO 2022/110030

(57) **Abstract**

Embodiments of this application disclose a semiconductor device and a manufacturing method thereof. The semiconductor device may include a substrate, a gate, a second dielectric layer, and a field plate. The substrate has a first dielectric layer, and a thickness of the first dielectric layer in a first area is greater than a thickness of the first dielectric layer in a second area outside the first area. The gate is located on the substrate and is located in the first area, the gate includes a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer. The second dielectric layer covers the gate and the first dielectric layer. The field plate is located on the second dielectric layer and is disposed in both the first area and the second area. In this way, capacitance between the second gate structure and a drain is reduced, and capacitance between the field plate and a channel is increased, so that parasitic capacitance of the device is reduced, and a gain characteristic of the device at a high frequency is improved.

## Description

### TECHNICAL FIELD

This application relates to the field of semiconductor manufacturing technologies, and in particular, to a semiconductor device and a manufacturing method thereof.

### BACKGROUND

In some applications, a radio frequency device is required to have a good gain characteristic at a high frequency. For example, third-generation compound semiconductor materials represented by gallium nitride (gallium nitride, GaN) and silicon carbide (SiC) have attracted wide attention due to excellent material characteristics, and a gallium nitride-based device is widely used in the field of radio frequency devices due to advantages such as high mobility, strong breakdown resistance, and good heat dissipation. However, a gallium nitride-based radio frequency device has a high index requirement for a high-frequency gain characteristic.

The gain characteristic of the radio frequency device at the high frequency mainly depends on whether a parasitic capacitor of the radio frequency device can perform efficient and fast charging and discharging actions based on a signal in a high-frequency working condition. Therefore, the gain characteristic of the radio frequency device at the high frequency may be effectively improved by reducing a capacitance value of the parasitic capacitor without changing another design structure of the radio frequency device. Currently, parasitic capacitance of the radio frequency device may be adjusted by changing a thickness or a dielectric constant of a dielectric layer. However, this adjustment manner easily causes another negative effect such as electrostatic breakdown.

### SUMMARY

In view of this, embodiments of this application provide a semiconductor device and a manufacturing method thereof. Parasitic capacitance of a radio frequency device is reduced by adjusting a structure of the semiconductor device, so that a gain characteristic of the radio frequency device at a high frequency is improved.

According to a first aspect, an embodiment of this application provides a semiconductor device including a substrate, a gate, a second dielectric layer, and a field plate. The substrate has a first dielectric layer, and a thickness of the first dielectric layer in a first area is greater than a thickness of the first dielectric layer in a second area outside the first area. The gate is located on the substrate and is located in the first area, the gate includes a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer. The second dielectric layer covers the gate and the first dielectric layer. The field plate is located on the second dielectric layer and disposed in both the first area and the second area. In this way, in comparison with capacitance in a semiconductor device with an equal-thickness first dielectric layer, in this semiconductor device, capacitance between the second gate structure and a drain is reduced due to a large thickness of the first dielectric layer in the first area, and capacitance between the field plate and a channel is increased due to a small thickness of the first dielectric layer in the second area, so that parasitic capacitance of the semiconductor device is reduced, and a gain characteristic of the semiconductor device at a high frequency is improved. In addition, this design may further re-adjust electric field stress inside the device. Because the thickness of the first dielectric layer in the first area is large, an electric field peak at the second gate structure is weakened, and overall robustness of the device is improved.

In some possible implementations, the semiconductor device further includes a source and a drain located in the substrate, where the gate is located between the source and the drain, the field plate faces, in the direction perpendicular to the surface of the substrate, a part that is of the gate and that faces the drain, and extends to the drain, and a part that is of the field plate and that is located in the second area is electrically connected to the source.

In this embodiment of this application, the semiconductor device may further include the source and the drain. The field plate may be connected to the source and extend to the drain, to modulate electric field and capacitance distribution between the source and the drain, thereby implementing a specific indicator of the high-frequency gain.

In some possible implementations, the first dielectric layer includes a first sub-film layer and a second sub-film layer.

The first sub-film layer covers the substrate, and the second sub-film layer is located in the first area on the first sub-film layer; or the first sub-film layer is located on the substrate and located in the first area, and the second sub-film layer covers the first sub-film layer and the substrate that is in the second area and that is outside the first sub-film layer.

In this embodiment of this application, the first dielectric layer may include a multi-layer structure, and the multi-layer structure is thick in the first area, so that a thickness of the first dielectric layer in the first area is greater than a thickness of the first dielectric layer in the second area. In this way, parasitic capacitance of the semiconductor device is reduced, and a gain characteristic of the semiconductor device at a high frequency is improved.

In some possible implementations, a material of at least one of the first sub-film layer and the second sub-film layer is at least one of silicon nitride, silicon oxynitride, silicon oxide, aluminum oxide, and titanium oxide.

In this embodiment of this application, materials of the first sub-film layer and the second sub-film layer may be set, to better control a dielectric constant of the first dielectric layer.

In some possible implementations, the substrate includes a base and an epitaxial layer, the epitaxial layer is disposed facing the gate, a material of the base is one or more of gallium nitride, aluminum nitride, silicon, silicon carbide, and sapphire, and the epitaxial layer includes one or more of gallium nitride, aluminum gallium nitride, indium aluminum nitride, aluminum nitride, and scandium aluminum nitride.

In this embodiment of this application, the substrate may include the base and the epitaxial layer, and the epitaxial layer may be used as a function layer, so that the semiconductor device has a personalized function.

In some possible implementations, a material of the gate and/or the field plate is at least one of nickel, titanium, aluminum, palladium, platinum, gold, titanium nitride, tantalum nitride, and copper.

In this embodiment of this application, materials of the gate and the field plate may be set, to implement better conductivity of the gate and the field plate.

In some possible implementations, a material of the second dielectric layer is at least one of silicon nitride, silicon oxynitride, silicon oxide, aluminum oxide, and titanium oxide.

In this embodiment of this application, a material of the second dielectric layer may be set, to implement better insulation of the second dielectric layer.

According to a second aspect, an embodiment of this application provides a semiconductor device manufacturing method, including:
providing a substrate;
forming a first dielectric layer and a gate on the substrate, where the gate is located on the substrate and is located in a first area; a thickness of the first dielectric layer in the first area is greater than a thickness of the first dielectric layer in a second area outside the first area; and the gate includes a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer;
forming a second dielectric layer covering the gate and the first dielectric layer; and
forming a field plate on the second dielectric layer, where the field plate is disposed in both the first area and the second area.

In some possible implementations, a source and a drain are further formed in the substrate; and the gate is located between the source and the drain, the field plate faces, in the direction perpendicular to the surface of the substrate, a part that is of the gate and that faces the drain, and extends to the drain, and a part that is of the field plate and that is located in the second area is electrically connected to the source.

In some possible implementations, the first dielectric layer includes a first sub-film layer and a second sub-film layer, and the forming a first dielectric layer and a gate on the substrate includes:
forming the first sub-film layer and a second sub-material layer sequentially on the substrate;
etching the second sub-material layer and the first sub-film layer in the first area to obtain a first via;
forming the first gate structure located inside the first via and the second gate structure that is connected to the first gate structure and that covers the part of the first dielectric layer; and
etching and removing the second sub-material layer outside the second gate structure by using the second gate structure as a mask, where the second sub-material layer located in the first area is used as the second sub-film layer.

In this embodiment of this application, the second sub-material layer may be etched by using the first sub-film layer as an etching stop layer and using the second gate structure as a hard self-aligning mask, without adding a sequential photo-lithography process. This can reduce costs.

In some possible implementations, the forming a first dielectric layer and a gate on the substrate includes:
forming a first dielectric material layer on the substrate;
etching the first dielectric material layer in the first area to obtain a second via;
forming the first gate structure located inside the second via and the second gate structure that is connected to the first gate structure and that covers the part of the first dielectric layer; and
thinning the first dielectric material layer in the second area outside the first area to form the first dielectric layer.

In this embodiment of this application, the second sub-material layer may be etched by using the second gate structure as a hard self-aligning mask, without adding a sequential photo-lithography process. This can reduce costs.

In some possible implementations, the first dielectric layer includes a first sub-film layer and a second sub-film layer, and the forming a first dielectric layer and a gate on the substrate includes:
forming a first sub-material layer on the substrate;
removing the first sub-material layer in the second area outside the first area, and using the first sub-material layer located in the first area as the first sub-film layer;
forming the second sub-film layer covering the first sub-film layer and the substrate;
etching the second sub-film layer and the first sub-film layer in the first area to obtain a third via; and
forming the first gate structure located inside the third via and the second gate structure that is connected to the first gate structure and that covers the part of the first dielectric layer.

In this embodiment of this application, the first sub-film layer in the first area may be first formed, and then the second sub-film layer is covered, so that a flat second sub-film layer is obtained.

In some possible implementations, the first dielectric layer includes a first sub-film layer and a second sub-film layer, and the forming a first dielectric layer and a gate on the substrate includes:
forming the first sub-film layer in the first area on the substrate by using a double-layer photoresist patterning process;
forming the second sub-film layer covering the first sub-film layer and the substrate;
etching the second sub-film layer and the first sub-film layer in the first area to obtain a third via; and
forming the first gate structure located inside the third via and the second gate structure that is connected to the first gate structure and that covers the part of the first dielectric layer.

In this embodiment of this application, the first sub-film layer may be first formed, and then the second sub-film layer that is located in the first area and that is on the first sub-film layer is formed, to help obtain the second sub-film layer accurately located under the second gate structure.

In some possible implementations, a material of the first sub-film layer and/or the second sub-film layer is at least one of silicon nitride, silicon oxynitride, silicon oxide, aluminum oxide, and titanium oxide.

In some possible implementations, the substrate includes a base and an epitaxial layer, a material of the base is one or more of gallium nitride, aluminum nitride, silicon, silicon carbide, and sapphire, and the epitaxial layer includes one or more of gallium nitride, aluminum gallium nitride, indium aluminum nitride, aluminum nitride, and scandium aluminum nitride.

In some possible implementations, a material of the gate and/or the field plate is at least one of nickel, titanium, aluminum, palladium, platinum, gold, titanium nitride, tantalum nitride, and copper.

In some possible implementations, a material of the second dielectric layer is at least one of silicon nitride, silicon oxynitride, silicon oxide, aluminum oxide, and titanium oxide.

According to a third aspect, an embodiment of this application provides an electronic device, including a circuit board and the semiconductor device that is connected to the circuit board and that is provided in the first aspect of this application.

It can be learned from the foregoing technical solutions that embodiments of this application have the following advantages:
Embodiments of this application provide a semiconductor device and a manufacturing method thereof. The semiconductor device may include a substrate, a gate, a second dielectric layer, and a field plate. The substrate has a first dielectric layer, and a thickness of the first dielectric layer in a first area is greater than a thickness of the first dielectric layer in a second area outside the first area. The gate is located on the substrate and is located in the first area, the gate includes a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer. The second dielectric layer covers the gate and the first dielectric layer. The field plate is located on the second dielectric layer and is disposed in both the first area and the second area. In this way, in comparison with capacitance in a semiconductor device with an equal-thickness first dielectric layer, in this semiconductor device, capacitance between the second gate structure and a drain is reduced due to a large thickness of the first dielectric layer in the first area, and capacitance between the field plate and a channel is increased due to a small thickness of the first dielectric layer in the second area, so that parasitic capacitance of the semiconductor device is reduced, and a gain characteristic of the semiconductor device at a high frequency is improved. In addition, this design may further re-adjust electric field stress inside the device. Because the thickness of the first dielectric layer in the first area is large, an electric field peak at the second gate structure is weakened, and overall robustness of the device is improved.

### BRIEF DESCRIPTION OF DRAWINGS

To clearly understand specific implementations of this application, the following briefly describes accompanying drawings for describing the specific implementations of this application. It is clear that the accompanying drawings show merely some embodiments of this application.
FIG. 1 is a schematic diagram of a structure of a radio frequency device according to an embodiment of this application;
FIG. 2 is a schematic diagram of transverse electric field stress distribution according to an embodiment of this application;
FIG. 3A, FIG. 3B, and FIG. 3C are schematic diagrams of structures of semiconductor devices according to embodiments of this application;
FIG. 4 is a schematic diagram of another transverse electric field stress distribution according to an embodiment of this application;
FIG. 5 is a flowchart of a semiconductor device manufacturing method according to an embodiment of this application; and
FIG. 6 to FIG. 23 are schematic diagrams of device structures in manufacturing processes of semiconductor devices according to embodiments of this application.

### DESCRIPTION OF EMBODIMENTS

Embodiments of this application provide a semiconductor device and a manufacturing method thereof. Parasitic capacitance of a radio frequency device is reduced by adjusting a structure of the semiconductor device, so that a gain characteristic of the radio frequency device at a high frequency is improved.

In the specification, claims, and accompanying drawings of this application, the terms "first", "second", "third", "fourth", and so on (if existent) are intended to distinguish between similar objects but do not necessarily indicate a specific order or sequence. It should be understood that data termed in such a way is interchangeable in proper circumstances, so that embodiments described herein can be implemented in other orders than the order illustrated or described herein. Moreover, the terms "include", "contain", and any other variants mean to cover a non-exclusive inclusion. For example, a process, method, system, product, or device that includes a series of steps or units is not necessarily limited to the expressly listed steps or units, but may include other steps or units not expressly listed or inherent to such a process, method, product, or device.

This application is described in detail with reference to the schematic diagrams. For ease of description, when embodiments of this application are described, a sectional view of a device structure is not partially enlarged according to a general proportion. The schematic diagrams are merely examples, and should not limit a protection scope of this application herein. In addition, three-dimensional space of a length, a width, and a depth should be included during actual production.

Currently, in some scenarios, a radio frequency device is required to have a good gain characteristic at a high frequency. The gain characteristic of the radio frequency device at the high frequency mainly depends on whether a parasitic capacitor of the radio frequency device can perform efficient and fast charging and discharging actions based on a signal in a high-frequency working condition. Therefore, the gain characteristic of the radio frequency device at the high frequency may be effectively improved by reducing a capacitance value of the parasitic capacitor without changing another design structure of the radio frequency device.

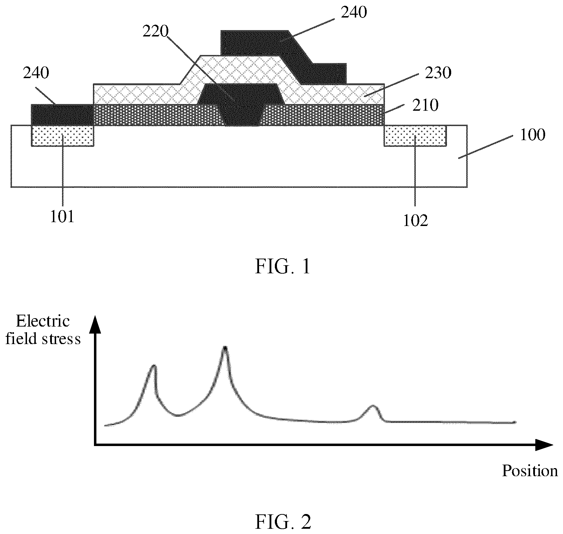

FIG. 1 is a schematic diagram of a structure of a radio frequency device according to an embodiment of this application. The radio frequency device includes a substrate 100, a first dielectric layer 210 on the substrate 100, a gate 220 that penetrates the first dielectric layer 210 and covers a part of the first dielectric layer 210, a second dielectric layer 230 that covers the gate 220 and the first dielectric layer 210, and a field plate 240 located on the second dielectric layer 230. The substrate 100 includes a source 101 and a drain 102, the field plate 240 is located on a side that is of the gate 220 and that faces the drain 102 and extends above the gate 220, and the field plate 240 is connected to the source 101. Factors that determine parasitic capacitance of the radio frequency device include parasitic capacitance C1 between a bottom of the gate 220 and the drain 102, parasitic capacitance C2 between a part that is of the gate 220 and that is located on the first dielectric layer 210 and the drain 102, and parasitic capacitance C3 between the field plate 204 and a channel below the gate 220. To reduce overall parasitic capacitance of the radio frequency device, C1 and C2 need to be reduced, and C3 needs to be increased, and the parasitic capacitance C1, C2, and C3 may be adjusted by changing a thickness or a dielectric constant of the dielectric layer. However, inventors find through research that this adjustment manner easily causes another negative effect, for example, generates electrostatic breakdown.

Specifically, increasing a thickness of the first dielectric layer 210 and reducing a dielectric constant of the first dielectric layer 210 may reduce the parasitic capacitance C2 between the part that is of the gate 220 and that is located on the first dielectric layer 210 and the drain 102, and may also reduce the parasitic capacitance C3 between the field plate 240 and the channel, but cannot reduce the overall parasitic capacitance of the device. However, reducing a thickness of the second dielectric layer 230 and increasing a dielectric constant of the second dielectric layer 230 can increase the parasitic capacitance C3 between the field plate 240 and the channel, and also cause deterioration of a voltage withstanding characteristic between the gate 220 and the field plate 240.

FIG. 2 is a schematic diagram of transverse electric field stress distribution according to an embodiment of this application. A horizontal coordinate is a position in a direction along a surface of the substrate, and a vertical coordinate is electric field stress at each position in a high-voltage reverse-biased stress state. A first electric field peak may correspond to an end that is at the bottom of the gate and that is close to the drain 102, a second electric field peak may correspond to an end that is at a top of the first dielectric layer 210 and that is close to the drain 102, and a third electric field peak may correspond to an end that is of the field plate 140 and that is close to the drain 102. As can be seen from the figure, the second electric field peak is the highest. Therefore, under continuous high electric field stress, if the thickness of the first dielectric layer 210 is small, the first dielectric layer 110 that is under the gate and that is at a position corresponding to the electric field peak is prone to time dependent dielectric breakdown (time dependent dielectric breakdown, TDDB), and has a high reliability risk. Therefore, C2 needs to be reduced to improve reliability of the device.

Based on the foregoing technical problems, embodiments of this application provide a semiconductor device and a manufacturing method thereof. The semiconductor device may include a substrate, a gate, a second dielectric layer, and a field plate. The substrate has a first dielectric layer, and a thickness of the first dielectric layer in a first area is greater than a thickness of the first dielectric layer in a second area outside the first area. The gate is located on the substrate and is located in the first area, the gate includes a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer. The second dielectric layer covers the gate and the first dielectric layer. The field plate is located on the second dielectric layer and is disposed in both the first area and the second area. In this way, in comparison with capacitance in a semiconductor device with an equal-thickness first dielectric layer, in this semiconductor device, capacitance between the second gate structure and a drain is reduced due to a large thickness of the first dielectric layer in the first area, and capacitance between the field plate and a channel is increased due to a small thickness of the first dielectric layer in the second area, so that parasitic capacitance of the semiconductor device is reduced, and a gain characteristic of the semiconductor device at a high frequency is improved. In addition, this design may further re-adjust electric field stress inside the device. Because the thickness of the first dielectric layer in the first area is large, an electric field peak at the second gate structure is weakened, and overall robustness of the device is improved.

To make the foregoing objectives, features, and advantages of this application clearer and easier to understand, the following describes specific implementations of this application in detail with reference to the accompanying drawings.

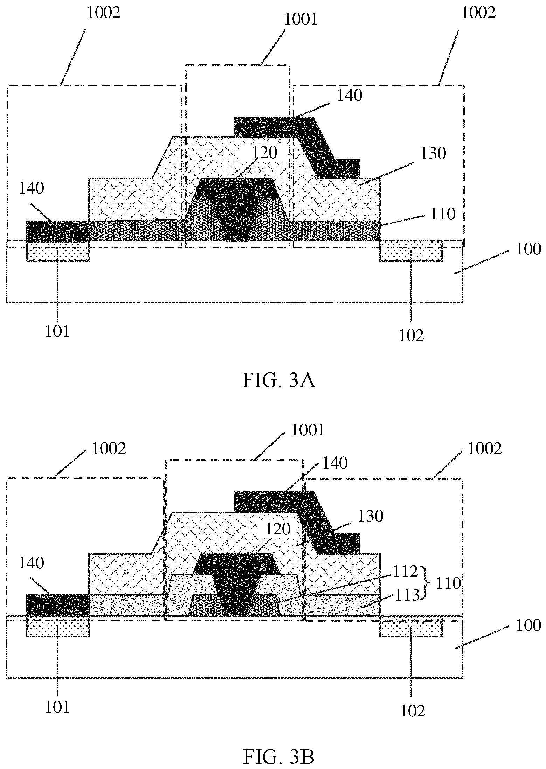

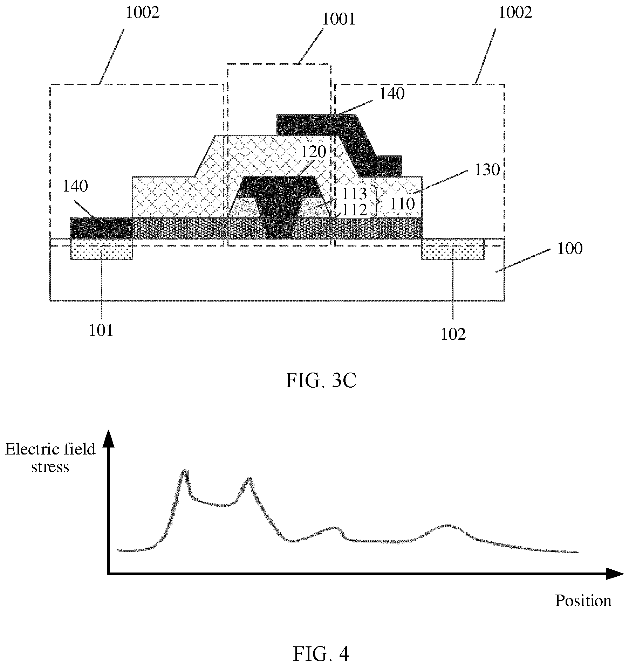

FIG. 3A, FIG. 3B, and FIG. 3C are schematic diagrams of structures of semiconductor devices according to embodiments of this application. The semiconductor structure includes a substrate 100, a gate 120, a first dielectric layer 110, a second dielectric layer 130, and a field plate 140.

In this embodiment of this application, the substrate 100 may be designed based on different device requirements. Specifically, the substrate 100 may include a base and an epitaxial layer. The epitaxial layer is formed on a surface of the base and is disposed towards the gate 120. The base may be a semiconductor base, for example, one or more of gallium nitride (GaN), aluminum nitride (AIN), silicon (Si), silicon carbide (SiC), and sapphire. The base may provide a support function for the semiconductor device, or constitute a part of a function layer of the semiconductor device. The epitaxial layer may be a film layer obtained through epitaxial growth on the base, and is usually a function layer constituting the semiconductor device, for example, may be one or more of gallium nitride (GaN), aluminum gallium nitride (AlGaN), indium aluminum nitride (InAIN), aluminum nitride (AlN), and scandium aluminum nitride (ScAlN). The materials of the base and the epitaxial layer may be the same, or may be different. The silicon carbide substrate may be of a single crystal structure, and may have a plurality of structure types, for example, 4H-silicon carbide, 6H-silicon carbide, and 3C-silicon carbide.

For example, when the semiconductor device is a high electron mobility transistor (high-electron-mobility transistor, HEMT) device based on gallium nitride, the base may be of a silicon carbide material, the epitaxial layer may include gallium nitride and aluminum gallium nitride, and the gallium nitride and the aluminum gallium nitride form a heterostructure to generate a two-dimensional electron gas, and the formed semiconductor device may work by using the two-dimensional electron gas generated by the heterostructure. Certainly, the semiconductor device in this embodiment of this application may alternatively be another radio frequency device, and the base and the epitaxial layer may also be correspondingly designed.

The substrate 100 has a first dielectric layer 110, and a thickness of the first dielectric layer 110 in a first area is greater than a thickness of the first dielectric layer 110 in a second area outside the first area. The first area is an area on the substrate, and includes space defined by a surface of the substrate and numerous straight lines perpendicular to the surface of the substrate. The first area is an area used to form a gate, and may be a central area of an area in which a source and a drain are located. The first area may be greater than an area in which the gate is located, or may be equal to the area in which the gate is located. Refer to FIG. 3A, FIG. 3B, and FIG. 3C. A dashed-line box in the middle represents a first area 1001, and dashed-line boxes on two sides of the first area 1001 represent a second area 1002. Because FIG. 3A, FIG. 3B, and FIG. 3C are sectional views, the second area 1002 may be actually located on two sides of the first area 1001, or may form a ring area, for example, a circular ring area or a polygon ring area, surrounding the first area 1001.

In this embodiment of this application, the first dielectric layer 110 may be a plurality of stacked layers of films, or may be an integrated structure of one layer of film. One layer of film may include a plurality of materials, or may include one material.

Specifically, the first dielectric layer 110 may be an integrated structure, and the first dielectric layer 110 in the second area outside the first area is thinned through etching, so that the first dielectric layer 110 has a small thickness. Refer to FIG. 3A. In a thinning process, a side wall at a boundary between the first area and the second area may not be strictly steep, and the side wall may be located in the first area. The first area may be equal to an area in which the gate 120 is located, or may be slightly greater than the area in which the gate 120 is located. A thickness range of the first dielectric layer 110 in the first area may be 40 nm to 1000 nm, and a thickness range of the first dielectric layer 110 in the second area outside the first area may be 20 nm to 500 nm. A material of the first dielectric layer 110 may be at least one of silicon nitride, silicon oxynitride, silicon oxide, aluminum oxide, and titanium oxide.

Specifically, the first dielectric layer 110 may include a first sub-film layer 112 and a second sub-film layer 113. Refer to FIG. 3B, the first sub-film layer 112 is located in a first area on the substrate 100, and the second sub-film layer 113 covers the first sub-film layer 112 and the substrate 100 in the second area outside the first sub-film layer 112. In this way, a difference between a thickness of the first dielectric layer 110 in the first area and a thickness of the first dielectric layer 110 in the second area outside the first area is a thickness of the first sub-film layer 112. Specifically, a part that is of the second sub-film layer 113 and that covers the side wall of the first sub-film layer 112 may be located in the first area, to define a large thickness of the first area. In this case, a size of the first sub-film layer 112 in a direction along the surface of the substrate is less than a size of the first area in the direction along the surface of the substrate. In this case, the first area may be greater than the area in which the gate is located, a thickness range of the first sub-film layer 112 may be 20 nm to 500 nm, and a material of the first sub-film layer 112 may be at least one of silicon nitride, silicon oxynitride, silicon oxide, aluminum oxide, and titanium oxide. A thickness range of the second sub-film layer 113 may be 20 nm to 500 nm, and a material of the second sub-film layer 113 may be at least one of silicon nitride, silicon oxynitride, silicon oxide, aluminum oxide, and titanium oxide.

Specifically, the first dielectric layer 110 may include the first sub-film layer 112 and the second sub-film layer 113. Refer to FIG. 3C. The first sub-film layer 112 covers the substrate 100, and the second sub-film layer 113 is located in the first area on the first sub-film layer 112. In this way, a difference between a thickness of the first dielectric layer 110 in the first area and a thickness of the first dielectric layer 110 in the second area outside the first area is a thickness of the second sub-film layer 113, and the second sub-film layer 113 may have a side wall that is not strictly steep enough. In this case, the side wall may be located in the first area. A thickness range of the first sub-film layer 112 may be 20 nm to 500 nm, and a material of the first sub-film layer 112 may be at least one of silicon nitride, silicon oxynitride, silicon oxide, aluminum oxide, and titanium oxide. A thickness range of the second sub-film layer 113 may be 20 nm to 500 nm, and a material of the second sub-film layer 113 may be at least one of silicon nitride, silicon oxynitride, silicon oxide, aluminum oxide, and titanium oxide.

The gate 120 is formed in the first area, the gate 120 includes a first gate structure and a second gate structure that are connected in a direction perpendicular to the surface of the substrate, and the first gate structure penetrates the first dielectric layer 110 on the substrate 100. Because the gate 120 is located in the first area, the first gate structure penetrates a thicker part of the first dielectric layer 110. The second gate structure is formed on the first dielectric layer 110 (in an upward direction in FIG. 3A, FIG. 3B, and FIG. 3C). To be specific, the second gate structure is formed on a side that is of the first dielectric layer and that is away from the substrate and covers a part of the first dielectric layer. In this case, a size of the second gate structure in a direction parallel to the surface of the substrate is greater than a size of the first gate structure in the direction parallel to the surface of the substrate. In other words, the first gate structure and the second gate structure may form a T-shaped structure. The first gate structure is connected to the substrate 100, and the second gate structure helps balance an electric field and capacitance inside the device. In addition, a gate dielectric layer may be further formed below the gate 120, and the gate dielectric layer is formed between the epitaxial layer and the first gate structure.

The substrate 100 may further include a source 101 and a drain 102. The source 101 and the drain 102 are respectively located on two sides of the gate 120, a channel area is included between the source 101 and the drain 102, the channel area is used to form a conductive channel when the device works, the first area is located above the channel area, and the gate 120 is also located above the channel area. The gate 120 may have good conductivity, and a material of the gate 120 may be at least one of nickel (Ni), titanium (Ti), aluminum (Al), palladium (Pd), platinum (Pt), gold (Au), titanium nitride (TiN), tantalum nitride (TaN), and copper (Cu). There is parasitic capacitor C1 between the first gate structure in the gate 120 and the drain 102, and the parasitic capacitor C1 is related to a size of the first gate structure. There is parasitic capacitor C2 between the second gate structure in the gate 120 and the drain 102, and the parasitic capacitor C2 is related to a thickness and a dielectric constant of the first dielectric layer 110 below the second gate structure.

The second dielectric layer 130 may cover the gate 120 and the first dielectric layer 110. The second dielectric layer 130 may protect the gate 120, or may be used as an isolation layer. A material of the second dielectric layer 130 may be at least one of silicon nitride, silicon oxynitride, silicon oxide, aluminum oxide, and titanium oxide, and a thickness range of the second dielectric layer 130 may be 20 nm to 500 nm.

The field plate 140 is located on the second dielectric layer 130. The field plate 140 may face a part that is of the gate and that faces the drain in a direction perpendicular to the surface of the substrate, and extend to the drain. In other words, the field plate 140 may be located on a side that is of the second gate structure and that faces the drain 102, and extend above the second gate structure (in an upward direction in FIG. 3A, FIG. 3B, and FIG. 3C). A part that is of the field plate 140 and that is located in the second area is electrically connected to the source 101 (refer to the field plate 140 on the source 101 in FIG. 3A, FIG. 3B, and FIG. 3C, where the field plate 140 on the source 101 is in an integrated structure with the field plate 140 at the top of the gate 120), and is configured to modulate electric field and capacitance distribution between the source and the drain, to implement a specific indicator of a high-frequency gain. A material of the field plate 140 is at least one of Ni, Ti, Al, Pd, Pt, Au, TiN, TaN, and Cu. The material of the field plate 140 and the material of the gate 120 may be the same or different. A thickness range of the field plate 140 is 20 nm to 1500 nm. When the device works, there is parasitic capacitor C3 between the field plate 140 and a conductive channel below the field plate 140. The parasitic capacitor affects an overall parasitic capacitor of the device, and is related to a thickness and a dielectric constant of the first dielectric layer 110 below the field plate 140, and a thickness and a dielectric constant of the second dielectric layer 130 below the field plate 140.

In this embodiment of this application, the first dielectric layer 110 is thicker in the first area, and is thinner in the second area outside the first area. To be specific, the thickness of the first dielectric layer 110 in the first area is greater than the thickness of the first dielectric layer 110 in the second area outside the first area. In this way, the capacitance C2 between the second gate structure and the drain 102 can be reduced without affecting the parasitic capacitance C3 between the field plate 140 and the conductive channel. Therefore, the overall parasitic capacitance of the device can be effectively reduced. In addition, because the thickness of the first dielectric layer 110 in the first area is large, electric potential and electric field distribution at an end that is of the gate 120 and that is close to the drain 102 may be adjusted, to effectively weaken electric field stress at a position in which a TDDB failure is likely to occur, to improve overall robustness of the device.

FIG. 4 is a schematic diagram of another transverse electric field stress distribution according to an embodiment of this application. A horizontal coordinate is a position in a direction along a surface of the substrate, and a vertical coordinate is an electric field stress at each position in a high-voltage reverse-biased stress state. A first electric field peak may correspond to an end that is of the first gate structure and that is close to the drain 102, a second electric field peak may correspond to an end that is of the second gate structure and that is close to the drain 102, a third electric field peak may correspond to an end that is of a bottom layer of the field plate 140 and that is close to the gate 120, and a fourth electric field peak may correspond to an end that is of the bottom layer of the field plate 140 and that is close to the drain. It can be learned from the figure that the second electric field peak is weakened, so that a risk of TDDB failure is reduced.

An embodiment of this application provides a semiconductor device, including a substrate, a gate, a second dielectric layer, and a field plate. The substrate has a first dielectric layer, and a thickness of the first dielectric layer in a first area is greater than a thickness of the first dielectric layer in a second area outside the first area. The gate is located on the substrate and is located in the first area, the gate includes a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer. The second dielectric layer covers the gate and the first dielectric layer. The field plate is located on the second dielectric layer and is disposed in both the first area and the second area. In this way, in comparison with capacitance in a semiconductor device with an equal-thickness first dielectric layer, in this semiconductor device, capacitance between the second gate structure and a drain is reduced due to a large thickness of the first dielectric layer in the first area, and capacitance between the field plate and a channel is increased due to a small thickness of the first dielectric layer in the second area, so that parasitic capacitance of the semiconductor device is reduced, and a gain characteristic of the semiconductor device at a high frequency is improved. In addition, this design may further re-adjust electric field stress inside the device. Because the thickness of the first dielectric layer in the first area is large, an electric field peak at the second gate structure is weakened, and overall robustness of the device is improved.

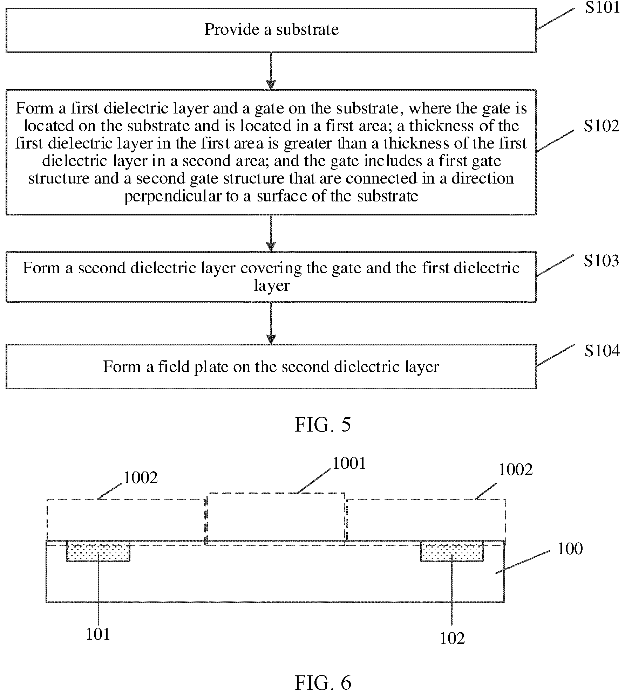

Based on the semiconductor device provided in embodiments of this application, an embodiment of this application further provides a semiconductor device manufacturing method. FIG. 5 is a flowchart of a semiconductor device manufacturing method according to an embodiment of this application. The method may include the following steps.

S101: Provide a substrate 100. Refer to FIG. 6.

In this embodiment of this application, the substrate 100 may be designed based on different device requirements. Specifically, the substrate 100 may include a base and an epitaxial layer. The epitaxial layer is formed on a surface of the base and is disposed towards a gate 120. The base may be a semiconductor base, for example, one or more of GaN, AlN, Si, SiC, and sapphire. The base may provide a support function for the semiconductor device, or constitute a part of a function layer of the semiconductor device. The epitaxial layer may be a film layer obtained through epitaxial growth on the base, and is usually a function layer constituting the semiconductor device, for example, may be one or more of GaN, AlGaN, InAlN, AlN, and ScAlN. The materials of the base and the epitaxial layer may be the same, or may be different. The silicon carbide substrate may be of a single crystal structure, and may have a plurality of structure types, for example, 4H-silicon carbide, 6H-silicon carbide, and 3C-silicon carbide.

In a gate-last process, a source and a drain may be formed before the gate 120, and the substrate 100 may further include a source 101 and a drain 102. A channel area may be included between the source 101 and the drain 102. The channel area is used to form a conductive channel when the device works. The source 101 and the drain 102 may be obtained by doping the substrate 100.

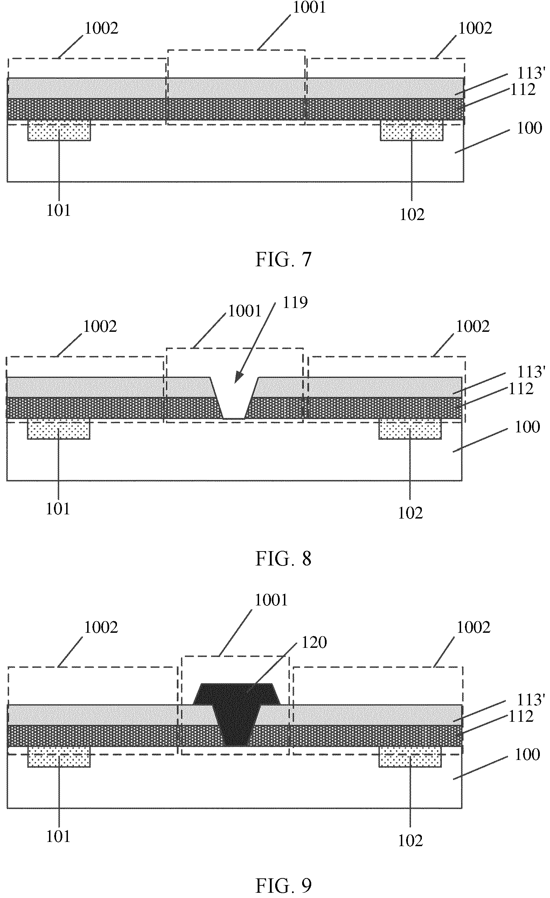

S102: Form a first dielectric layer on the substrate 100, and form a gate 120 in a first area on the substrate 100, where a thickness of the first dielectric layer 110 in the first area is greater than a thickness of the first dielectric layer 110 in a second area outside the first area; and the gate 120 includes a first gate structure and a second gate structure that are connected in a direction perpendicular to a surface of the substrate. Refer to FIG. 7 to FIG. 10, FIG. 12 to FIG. 15, and FIG. 17 to FIG. 22.

In this embodiment of this application, a first dielectric layer 110 may be formed on the substrate 100, and the thickness of the first dielectric layer 110 in the first area is greater than the thickness of the first dielectric layer 110 in the second area outside the first area. The first area may be an area used to form the gate, and may be a central area of an area in which the source and the drain are located. The first area may be greater than an area in which the gate is located, or may be equal to the area in which the gate is located. The first dielectric layer 110 may be formed before the gate 120, or may be formed in a process of forming the gate 120.

In this embodiment of this application, the gate 120 is formed in the first area, the gate 120 includes a first gate structure and a second gate structure that are connected in a direction perpendicular to the surface of the substrate, and the first gate structure penetrates the first dielectric layer 110 on the substrate 100. Because the gate 120 is located in the first area, the first gate structure penetrates a thicker part of the first dielectric layer 110. The second gate structure is formed on the first dielectric layer 110 (in an upward direction in FIG. 3A, FIG. 3B, and FIG. 3C). In this case, a size of the second gate structure in a direction parallel to the surface of the substrate is greater than a size of the first gate structure in the direction parallel to the surface of the substrate. In other words, the first gate structure and the second gate structure may form a T-shaped structure. A gate dielectric layer may be further formed below the gate 120, and the gate dielectric layer is formed between the epitaxial layer and the first gate structure. The gate 120 may have good conductivity, and a material of the gate 120 may be at least one of Ni, Ti, Al, Pd, Pt, Au, TiN, TaN, and Cu. There is parasitic capacitor C1 between the first gate structure in the gate 120 and the drain 102, and the parasitic capacitor is related to a size of the first gate structure. There is parasitic capacitor C2 between the second gate structure in the gate 120 and the drain 102, and the parasitic capacitor C2 is related to a thickness and a dielectric constant of the first dielectric layer 110 below the second gate structure.

In this embodiment of this application, the first dielectric layer 110 is thicker in the first area, and is thinner in the second area outside the first area. To be specific, the thickness of the first dielectric layer 110 in the first area is greater than the thickness of the first dielectric layer 110 in the second area outside the first area. In this way, the capacitance between the second gate structure and the drain 102 can be reduced without affecting parasitic capacitance of another position. Therefore, the overall parasitic capacitance of the device can be effectively reduced. In addition, because the thickness of the first dielectric layer 110 in the first area is large, electric potential and electric field distribution at an end that is of the gate 120 and that is close to the drain 102 may be adjusted, to effectively weaken electric field stress at a position in which a TDDB failure is likely to occur, to improve overall robustness of the device.

In this embodiment of this application, the first dielectric layer 110 may be a plurality of stacked layers of films, or may be an integrated structure of one layer of film. One layer of film may include a plurality of materials, or may include one material.

In a possible manner of forming the first dielectric layer 110 and the gate 120, the first dielectric layer 110 may include a first sub-film layer 112 and a second sub-film layer 113. In this case, the first sub-film layer 112 and a second sub-material layer 113' may be first successively deposited on the substrate 100. Refer to FIG. 7. A thickness range of the first sub-film layer 112 may be 20 nm to 500 nm, and a material of the first sub-film layer 112 may be at least one of silicon nitride, silicon oxynitride, silicon oxide, aluminum oxide, and titanium oxide. Athickness range of the second sub-material layer 113' may be 20 nm to 500 nm, and a material of the second sub-material layer 113' may be at least one of silicon nitride, silicon oxynitride, silicon oxide, aluminum oxide, and titanium oxide. The first sub-film layer 112 and the second sub-material layer 113' may have different refractive indexes, densities, and etching resistance degrees. The first sub-film layer 112 and the second sub-material layer 113' may be of a same material or different materials. When the first sub-film layer 112 and the second sub-material layer 113' have a same material layer, the first sub-film layer 112 and the second sub-material layer 113' may have different deposition temperatures, so that the first sub-film layer 112 and the second sub-material layer 113' have different refractive indexes, densities, and etching resistance degrees.

Then, the second sub-material layer 113' and the first sub-film layer 112 in the first area may be etched, to obtain a first via 119. Refer to FIG. 8. The second sub-material layer 113' and the first sub-film layer 112 may be etched by using a photo-lithography process. An etching manner may be anisotropic dry etching or wet etching. The first via 119 is located in the first area, to expose the substrate 100 in the first area. When a gate dielectric layer is formed on the substrate 100, the first via 119 may expose the gate dielectric layer.

Then, a first gate structure located inside the first via 119 and a second gate structure that is connected to the first gate structure and that covers a part of the first dielectric layer may be formed, to obtain the gate 120. Refer to FIG. 9. The first gate structure and the second gate structure may be formed through deposition and etching. Specifically, a conductor material may be deposited, so that the conductor material fills the first via 119 and covers the first via 119. A thickness range of the conductor material may be 20 nm to 1500 nm, and the conductor material may be at least one of Ni, Ti, Al, Pd, Pt, Au, TiN, TaN, and Cu. Then, the conductor material outside the first area may be removed to form the gate 120 located in the conductor area.

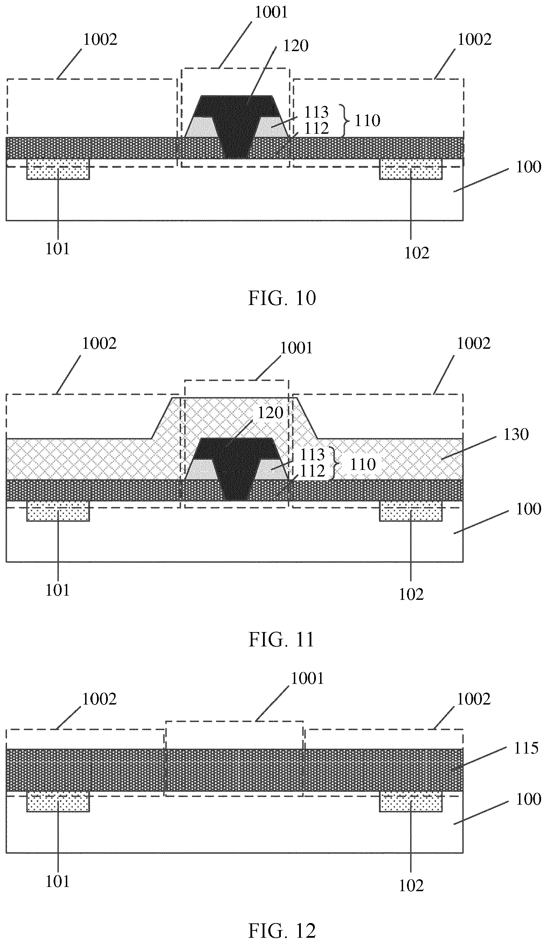

Then, the second sub-material layer 113' outside the second gate structure may be etched and removed by using the second gate structure as a mask, where the second sub-material layer 113' located in the first area is used as the second sub-film layer 113. Refer to FIG. 10. Because there is an etching resistance difference between the first sub-film layer 112 and the second sub-material layer, the second sub-material layer 113' may be etched by using the first sub-film layer 112 as an etching stop layer and using the second gate structure as a hard self-aligning mask, to obtain the second sub-film layer 113. An etched surface stays at a position between the first sub-film layer 112 and the second sub-material layer 113', an etched thickness is a thickness of the second sub-material layer 113', and an etching manner may be anisotropic dry etching or wet etching. Because the second gate structure may be used as the mask, there is no need to add a sequential photo-lithography process, and costs can be saved. It is clear that the etching of the second sub-material layer 113' may alternatively be performed by using a photo-lithography process before the first gate structure and the second gate structure are formed. Details are not described herein.

In other words, the first dielectric layer 110 may include the first sub-film layer 112 and the second sub-film layer 113. The first sub-film layer 112 covers the substrate 100, and the second sub-film layer 113 is located in the first area on the first sub-film layer 112. In this way, a difference between a thickness of the first dielectric layer 110 in the first area and a thickness of the first dielectric layer 110 in the second area outside the first area is a thickness of the second sub-film layer 113. A material of the first sub-film layer 112 and/or the second sub-film layer 113 is at least one of silicon nitride, silicon oxynitride, silicon oxide, aluminum oxide, and titanium oxide.

In another possible manner of forming the first dielectric layer 110 and the gate 120, a first dielectric material layer 115 may be first deposited on the substrate 100. Refer to FIG. 12. Athickness range of the first dielectric material layer 115 may be 40 nm to 1000 nm, and a material of the first dielectric material layer 115 may be at least one of silicon nitride, silicon oxynitride, silicon oxide, aluminum oxide, and titanium oxide.

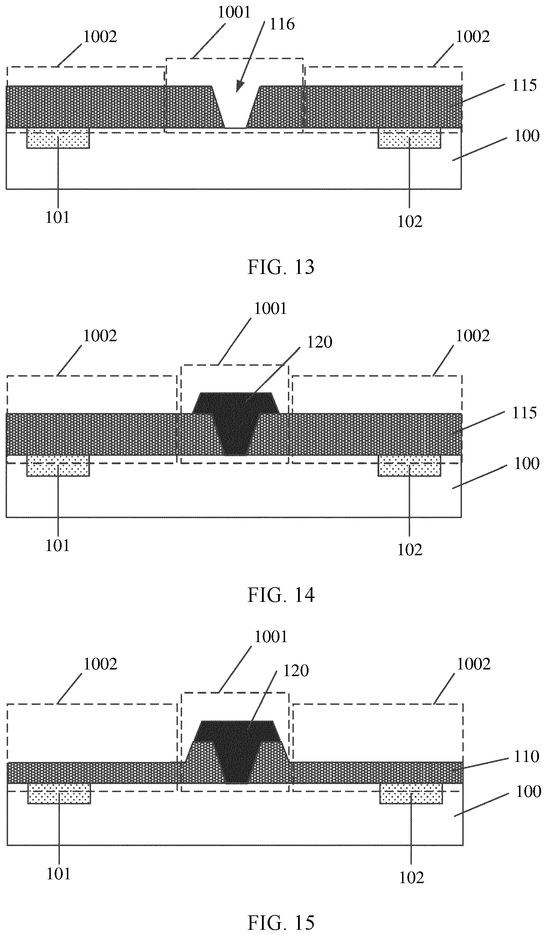

Then, the first dielectric material layer 115 in the first area may be etched, to obtain a second via 116. Refer to FIG. 13. The first dielectric material layer 115 may be etched by using a photo-lithography process. An etching manner may be anisotropic dry etching or wet etching. The second via 116 is located in the first area, to expose the substrate 100 in the first area. When a gate dielectric layer is formed on the substrate 100, the second via 116 may expose the gate dielectric layer.

Then, a first gate structure located inside the second via 116 and a second gate structure that is connected to the first gate structure and that covers a part of the first dielectric layer may be formed, to form the gate 120. Refer to FIG. 14. The first gate structure and the second gate structure may be formed through deposition and etching. Specifically, a conductor material may be deposited, so that the conductor material fills the second via 116 and covers the second via 116. A thickness range of the conductor material may be 20 nm to 1500 nm, and the conductor material may be at least one of Ni, Ti, Al, Pd, Pt, Au, TiN, TaN, and Cu. Then, the conductor material outside the first area may be removed to form the gate 120 located in the conductor area.

Then, the first dielectric material layer 115 outside the first area may be etched, to remove a part with a specific thickness that is of the first dielectric material layer 115 and that is in the second area outside the first area. That is, the first dielectric material layer 115 in the second area is thinned, to form the first dielectric layer 110. Refer to FIG. 15. In an etching process, a second gate structure is used as a hard self-aligning mask, an etched thickness may be controlled by using an etching rate and an etching duration, a thickness range may be 20 nm to 500 nm, and an etching manner may be anisotropic dry etching or wet etching. Because the first dielectric layer 110 in the second area outside the first area is thinned through etching, the first dielectric layer 110 in the second area is thin in thickness. Specifically, a thickness of the first dielectric layer 110 in the first area is a deposition thickness of the first dielectric material layer 115, a thickness range of the first dielectric layer 110 in the first area may be 40 nm to 1000 nm, and a thickness range of the first dielectric layer 110 in the second area outside the first area may be 20 nm to 500 nm. Because the second gate structure may be used as the mask, there is no need to add a sequential photo-lithography process. This can reduce costs. It is clear that the etching of the first dielectric material layer 115 in the second area outside the first area may alternatively be performed by using a photo-lithography process before the first gate structure and the second gate structure are formed. Details are not described herein.

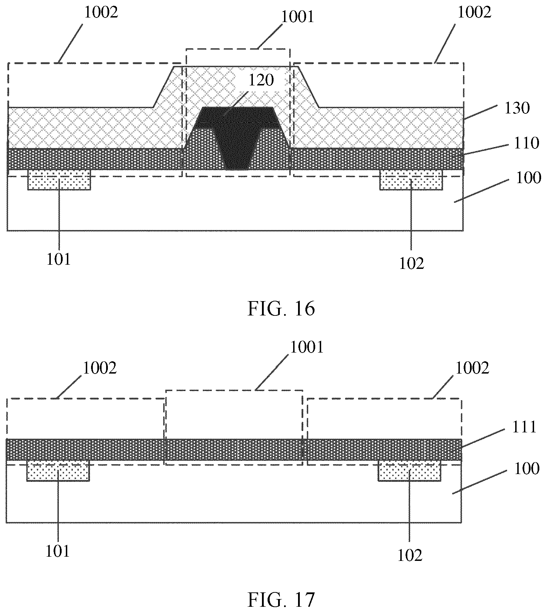

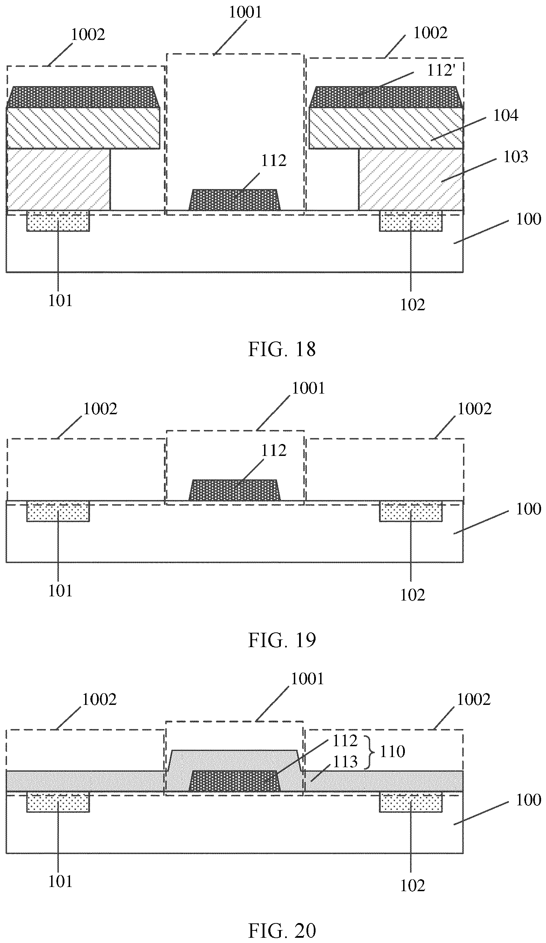

In still another possible manner of forming the first dielectric layer 110 and the gate 120, the first dielectric layer includes a first sub-film layer 112 and a second sub-film layer 113. In this case, a first sub-material layer 111 may be deposited on the substrate 100. Refer to FIG. 17. Then, a first sub-material layer 111 in the second area outside the first area is removed, and the third sub-material layer 111 in the first area is used as the first sub-film layer 112. Refer to FIG. 19. A thickness range of the first sub-material layer 111 may be 20 nm to 500 nm, and a material of the first sub-material layer 111 may be at least one of silicon nitride, silicon oxynitride, silicon oxide, aluminum oxide, and titanium oxide. The first sub-material layer 111 may be etched by using a photo-lithography process. An etching manner may be anisotropic dry etching or wet etching.

Then, the second sub-film layer 113 covering the first sub-film layer 112 and the substrate 100 may be formed. Refer to FIG. 20. The second sub-film layer 113 may be formed through deposition, a thickness range of the second sub-film layer 113 may be 20 nm to 500 nm, and a material of the second sub-film layer 113 may be at least one of silicon nitride, silicon oxynitride, silicon oxide, aluminum oxide, and titanium oxide. The second sub-film layer 113 may cover an upper surface and a side wall that are of the first sub-film layer 112, and the substrate 100 outside the first sub-film layer 112.

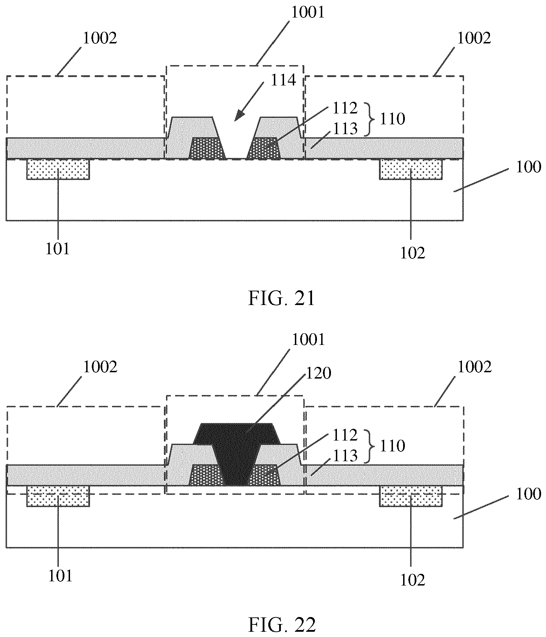

Then, the second sub-film layer 113 and the first sub-film layer 112 in the first area may be etched, to obtain a third via 114. Refer to FIG. 21. The second sub-film layer 113 and the first sub-film layer 112 may be etched by using a photo-lithography process. An etching manner may be anisotropic dry etching or wet etching. The third via 114 may be disposed in the first area, to expose the substrate 100 in the first area. When a gate dielectric layer is formed on the substrate 100, the third via 114 may expose the gate dielectric layer.

Then, a first gate structure located inside the third via 114 and a second gate structure that is connected to the first gate structure and that covers a part of the first dielectric layer may be formed, to form the gate 120. Refer to FIG. 22. The first gate structure and the second gate structure may be formed through deposition and etching. Specifically, a conductor material may be deposited, so that the conductor material fills the third via 114 and covers the third via 114. A thickness range of the conductor material may be 20 nm to 1500 nm, and the conductor material may be at least one of Ni, Ti, Al, Pd, Pt, Au, TiN, TaN, and Cu. Then, the conductor material outside the first area may be removed to form the gate 120 located in the conductor area.

In yet another possible manner of forming the first dielectric layer 110 and the gate 120, the first dielectric layer includes a first sub-film layer 112 and a second sub-film layer 113, and the first sub-film layer 112 may be formed on the substrate 100 in the first area by using a double-layer photoresist patterning process. A double-layer photoresist pattern includes a first photoresist 103 that has a large opening and that is located at a lower layer and a second photoresist 104 that has a small opening and that is located at an upper layer. In this way, a position of the first sub-film layer 112 is defined by using the openings in the double-layer photoresist. Refer to FIG. 18. Then, the first sub-film layer 112 may be formed in the openings by using a deposition process. It is clear that a dielectric material is also formed on the photoresist layer during deposition. Refer to FIG. 18. A thickness range of the first sub-film layer 112 may be 20 nm to 500 nm, and a material of the first sub-film layer 112 may be at least one of silicon nitride, silicon oxynitride, silicon oxide, aluminum oxide, and titanium oxide. Then, the double-layer photoresist 103/104 and the dielectric material on the double-layer photoresist 103/104 may be removed through dry etching or wet etching. Refer to FIG. 19. Then the first sub-film layer 112 may be cleaned through dry treatment and/or wet treatment.

Then, the second sub-film layer 113 covering the first sub-film layer 112 and the substrate 100 may be formed. The second sub-film layer 113 and the first sub-film layer 112 in the first area are etched to obtain a third via 114, to form a first gate structure inside the third via 114 and a second gate structure that is connected to the first gate structure and that covers a part of the first dielectric layer. For formation of the second sub-film layer 113, formation of the third via, and formation of the first gate structure and the second gate structure, refer to the foregoing method, and FIG. 20, FIG. 21, and FIG. 22. Details are not described herein again.

In other words, the first dielectric layer 110 may include the first sub-film layer 112 and the second sub-film layer 113. The first sub-film layer 112 is located in the first area on the substrate 100, and the second sub-film layer 113 covers the first sub-film layer 112 and the substrate 100 in the second area outside the first sub-film layer 112. In this way, a difference between a thickness of the first dielectric layer 110 in the first area and a thickness of the first dielectric layer 110 in the second area outside the first area is a thickness of the first sub-film layer 112.

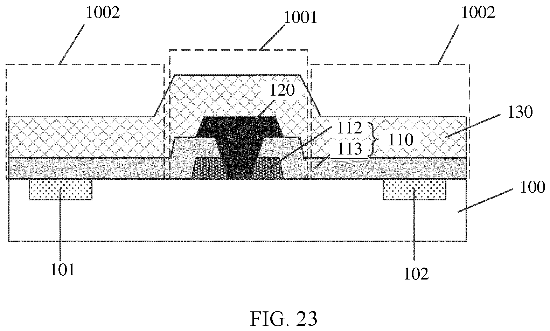

S103: Form a second dielectric layer 130 covering the gate 120 and the first dielectric layer 110. Refer to FIG. 11, FIG. 16, and FIG. 23.

After the gate 120 is formed, the second dielectric layer 130 covering the gate 120 and the first dielectric layer 110 may be formed. The second dielectric layer 130 may protect the gate 120, or may be used as an isolation layer. The second dielectric layer 130 may be formed through deposition, a material of the second dielectric layer 130 may be at least one of silicon nitride, silicon oxynitride, silicon oxide, aluminum oxide, and titanium oxide, and a thickness range of the second dielectric layer 130 may be 20 nm to 500 nm.

In a gate-first process, after the second dielectric layer 130 is formed, the second dielectric layer 130 and the first dielectric layer 110 may be etched to expose a source and drain area of the substrate 100, to form the source 10 1 and the drain 102.

S104: Form a field plate 140 on the second dielectric layer 130. Refer to FIG. 1, FIG. 3A to FIG. 3C, and FIG. 4.

After the second dielectric layer 130 is formed, the field plate 140 may be formed on the second dielectric layer 130. The field plate 140 may face a part that is of the gate and that faces the drain in a direction perpendicular to a surface of the substrate, and extend to the drain. In other words, the field plate 140 may be located on a side that is of the second gate structure and that faces the drain 102, and extend above the second gate structure (in an upward direction in FIG. 3A, FIG. 3B, and FIG. 3C). A part that is of the field plate 140 and that is located in the second area is electrically connected to the source 101 (refer to the field plate 140 on the source 101 in FIG. 3A, FIG. 3B, and FIG. 3C, where the field plate 140 on the source 101 is in an integrated structure with the field plate 140 at the top of the gate 120), and is configured to modulate electric field and capacitance distribution between the source and the drain, to implement a specific indicator of a high-frequency gain. A material of the field plate 140 is at least one of Ni, Ti, Al, Pd, Pt, Au, TiN, TaN, and Cu. The material of the field plate 140 and the material of the gate 120 may be the same or different. A thickness range of the field plate 140 is 20 nm to 1500 nm. When the device works, there is parasitic capacitor C3 between the field plate 140 and a conductive channel below the field plate 140. The parasitic capacitor affects an overall parasitic capacitor of the device, and is related to a thickness and a dielectric constant of the first dielectric layer 110 below the field plate 140, and a thickness and a dielectric constant of the second dielectric layer 130 below the field plate 140.

Because a thickness of an area that is of the first dielectric layer 110 and that is under the second gate structure is greater than a thickness of the first dielectric layer 110 in the second area outside the second gate structure, capacitance between the second gate structure and the drain 102 can be reduced without affecting parasitic capacitance between the field plate 140 and the channel. Therefore, parasitic capacitance of the entire device can be effectively reduced.

An embodiment of this application provides a semiconductor device manufacturing method. The method includes: providing a substrate; forming a first dielectric layer and a gate on the substrate, where a thickness of the first dielectric layer in a first area is greater than a thickness of the first dielectric layer in a second area outside the first area, the gate is located on the substrate and is located in the first area, the gate includes a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer; then forming a second dielectric layer covering the gate and the first dielectric layer; and forming a field plate on the second dielectric layer, where the field plate is disposed in both the first area and the second area. In this way, in comparison with capacitance in a semiconductor device with an equal-thickness first dielectric layer, in this semiconductor device, capacitance between the second gate structure and a drain is reduced due to a large thickness of the first dielectric layer in the first area, and capacitance between the field plate and a channel is increased due to a small thickness of the first dielectric layer in the second area, so that parasitic capacitance of the semiconductor device is reduced, and a gain characteristic of the semiconductor device at a high frequency is improved. In addition, this design may further re-adjust electric field stress inside the device. Because the thickness of the first dielectric layer in the first area is large, an electric field peak at the second gate structure is weakened, and overall robustness of the device is improved.

Based on the semiconductor device provided in embodiments of this application, an embodiment of this application further provides an electronic device. The electronic device includes a circuit board and a semiconductor device connected to the circuit board. The semiconductor device may be any semiconductor device provided in the foregoing specification. The circuit board may be a printed circuit board (printed circuit board, PCB). It is clear that the circuit board may alternatively be a flexible circuit board (FPC), and the like. The circuit board is not limited in this embodiment. Optionally, the electronic device is different types of user equipment or terminal devices such as a computer, a mobile phone, a tablet computer, a wearable device, and a vehicle-mounted device. The electronic device may alternatively be a network device such as a base station.

Optionally, the electronic device further includes a package substrate. The package substrate is fastened to the printed circuit board PCB by using a solder ball, and the semiconductor device is fastened to the package substrate by using a solder ball.

Another aspect of this application further provides a non-transitory computer-readable storage medium for use with a computer. The computer has software for creating an integrated circuit. The computer-readable storage medium stores one or more computer-readable data structures. The one or more computer-readable data structures have optical mask data for manufacturing the integrated circuit provided in any one of the figures provided in the foregoing specification.

Embodiments in this specification are all described in a progressive manner. For same or similar parts in the embodiments, refer to these embodiments. Each embodiment focuses on a difference from other embodiments.

The foregoing are specific implementations of this application. It should be understood that, the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A semiconductor device, comprising:
a substrate, wherein the substrate has a first dielectric layer, and a thickness of the first dielectric layer in a first area is greater than a thickness of the first dielectric layer in a second area outside the first area;
a gate, wherein the gate is located on the substrate and is located in the first area, the gate comprises a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer;
a second dielectric layer covering the gate and the first dielectric layer; and
a field plate located on the second dielectric layer, wherein the field plate is disposed in both the first area and the second area.

2. The semiconductor device according to claim 1, further comprising a source and a drain located in the substrate, wherein the gate is located between the source and the drain, the field plate faces, in the direction perpendicular to the surface of the substrate, a part that is of the gate and that faces the drain, and extends to the drain, and a part that is of the field plate and that is located in the second area is electrically connected to the source.

3. The semiconductor device according to claim 1 or 2, wherein the first dielectric layer comprises a first sub-film layer and a second sub-film layer; and
the first sub-film layer covers the substrate, and the second sub-film layer is located in the first area on the first sub-film layer; or the first sub-film layer is located on the substrate and located in the first area, and the second sub-film layer covers the first sub-film layer and the substrate that is in the second area and that is outside the first sub-film layer.

4. The semiconductor device according to claim 3, wherein a material of at least one of the first sub-film layer and the second sub-film layer is at least one of silicon nitride, silicon oxynitride, silicon oxide, aluminum oxide, and titanium oxide.

5. The semiconductor device according to any one of claims 1 to 4, wherein the substrate comprises a base and an epitaxial layer, the epitaxial layer is disposed facing the gate, a material of the base is one or more of gallium nitride, aluminum nitride, silicon, silicon carbide, and sapphire, and the epitaxial layer comprises one or more of gallium nitride, aluminum gallium nitride, indium aluminum nitride, aluminum nitride, and scandium aluminum nitride.

6. The semiconductor device according to any one of claims 1 to 5, wherein a material of the gate and/or the field plate is at least one of nickel, titanium, aluminum, palladium, platinum, gold, titanium nitride, tantalum nitride, and copper.

7. The semiconductor device according to any one of claims 1 to 6, wherein a material of the second dielectric layer is at least one of silicon nitride, silicon oxynitride, silicon oxide, aluminum oxide, and titanium oxide.

8. A semiconductor device manufacturing method, comprising:
providing a substrate;
forming a first dielectric layer and a gate on the substrate, wherein the gate is located on the substrate and is located in a first area; a thickness of the first dielectric layer in the first area is greater than a thickness of the first dielectric layer in a second area outside the first area; and the gate comprises a first gate structure and a second gate structure that are connected in a direction perpendicular to a surface of the substrate, the first gate structure penetrates the first dielectric layer in the direction perpendicular to the surface of the substrate, and the second gate structure is formed on a side that is of the first dielectric layer and that is away from the substrate and covers a part of the first dielectric layer;
forming a second dielectric layer covering the gate and the first dielectric layer; and
forming a field plate on the second dielectric layer, wherein the field plate is disposed in both the first area and the second area.

9. The method according to claim 8, wherein a source and a drain are further formed in the substrate; and the gate is located between the source and the drain, the field plate faces, in the direction perpendicular to the surface of the substrate, a part that is of the gate and that faces the drain, and extends to the drain, and a part that is of the field plate and that is located in the second area is electrically connected to the source.

10. The method according to claim 8 or 9, wherein the first dielectric layer comprises a first sub-film layer and a second sub-film layer, and the forming a first dielectric layer and a gate on the substrate comprises:
forming the first sub-film layer and a second sub-material layer sequentially on the substrate;
etching the second sub-material layer and the first sub-film layer in the first area to obtain a first via;
forming the first gate structure located inside the first via and the second gate structure that is connected to the first gate structure and that covers the part of the first dielectric layer; and
etching and removing the second sub-material layer outside the second gate structure by using the second gate structure as a mask, wherein the second sub-material layer located in the first area is used as the second sub-film layer.

11. The method according to claim 8 or 9, wherein the forming a first dielectric layer and a gate on the substrate comprises:
forming a first dielectric material layer on the substrate;
etching the first dielectric material layer in the first area to obtain a second via;
forming the first gate structure located inside the second via and the second gate structure that is connected to the first gate structure and that covers the part of the first dielectric layer; and
thinning the first dielectric material layer in the second area outside the first area to form the first dielectric layer.

12. The method according to claim 8 or 9, wherein the first dielectric layer comprises a first sub-film layer and a second sub-film layer, and the forming a first dielectric layer and a gate on the substrate comprises:
forming a first sub-material layer on the substrate;
removing the first sub-material layer in the second area outside the first area, and using the first sub-material layer located in the first area as the first sub-film layer;
forming the second sub-film layer covering the first sub-film layer and the substrate;
etching the second sub-film layer and the first sub-film layer in the first area to obtain a third via; and
forming the first gate structure located inside the third via and the second gate structure that is connected to the first gate structure and that covers the part of the first dielectric layer.

13. The method according to claim 8 or 9, wherein the first dielectric layer comprises a first sub-film layer and a second sub-film layer, and the forming a first dielectric layer and a gate on the substrate comprises:
forming the first sub-film layer in the first area on the substrate by using a double-layer photoresist patterning process;
forming the second sub-film layer covering the first sub-film layer and the substrate;
etching the second sub-film layer and the first sub-film layer in the first area to obtain a third via; and
forming the first gate structure located inside the third via and the second gate structure that is connected to the first gate structure and that covers the part of the first dielectric layer.

14. The method according to any one of claims 10 to 13, wherein a material of the first sub-film layer and/or the second sub-film layer is at least one of silicon nitride, silicon oxynitride, silicon oxide, aluminum oxide, and titanium oxide.

15. The method according to any one of claims 8 to 14, wherein the substrate comprises a base and an epitaxial layer, a material of the base is one or more of gallium nitride, aluminum nitride, silicon, silicon carbide, and sapphire, and the epitaxial layer comprises one or more of gallium nitride, aluminum gallium nitride, indium aluminum nitride, aluminum nitride, and scandium aluminum nitride.

16. The method according to any one of claims 8 to 15, wherein a material of the gate and/or the field plate is at least one of nickel, titanium, aluminum, palladium, platinum, gold, titanium nitride, tantalum nitride, and copper.

17. The method according to any one of claims 8 to 16, wherein a material of the second dielectric layer is at least one of silicon nitride, silicon oxynitride, silicon oxide, aluminum oxide, and titanium oxide.

18. An electronic device, comprising a circuit board, and the semiconductor device according to any one of claims 1 to 7 that is connected to the circuit board.
